# EUROPÄISCHE PATENTSCHRIFT

(11) **EP 0 507 974 B1**
(45) Veröffentlichungstag und Bekanntmachung des Hinweises auf die Patenterteilung: **20.12.1995**
(21) Anmeldenummer: 91105724.8
(22) Anmeldetag: 11.04.1991
(51) Int. Cl.: H01L 29/74

(54) **Abschaltbares, MOS-gesteuertes Leistungshalbleiter-Bauelement**
MOS-gated turn-off power semiconductor device
Dispositif semi-conducteur de puissance, ouvrable, à commande de type MOS

(43) Veröffentlichungstag der Anmeldung: 14.10.1992
(73) Patentinhaber: ASEA BROWN BOVERI AG, 5400 Baden (CH)
(72) Erfinder: Bauer, Friedhelm, Dr., CH-5400 Baden (CH); Vuilleumier, Raymond, Dr., CH-2052 Fontainemelon (CH)

(56) Entgegenhaltungen:
- EP-A- 0 028 797
- EP-A- 0 219 995
- DE-A- 4 024 526

## Beschreibung

### TECHNISCHES GEBIET

Die vorliegende Erfindung bezieht sich auf das Gebiet der Leistungselektronik. Sie betrifft insbesondere ein abschaltbares, MOS-gesteuertes Leistungshalbleiter-Bauelement, umfassend
(a) ein Halbleitersubstrat von einem ersten Leitfähigkeitstyp, welches Halbleitersubstrat auf der einen Seite durch eine erste Hauptfläche und auf der anderen Seite durch eine zweite Hauptfläche begrenzt wird und in seinem Inneren eine erste Basisschicht bildet;
(b) eine Emitterschicht von einem zweiten, zum ersten entgegengesetzten Leitfähigkeitstyp, welche Emitterschicht von der zweiten Hauptfläche her in die erste Basisschicht hineinragt;
(c) eine zweite Basisschicht vom zweiten Leitfähigkeitstyp, welche zweite Basisschicht von der ersten Hauptfläche her in die erste Basisschicht hineinragt;
(d) eine Mehrzahl von ersten Emittergebieten vom ersten Leitfähigkeitstyp, welche von der ersten Hauptfläche (H1) her in die zweite Basisschicht hineinragen;
(e) eine Mehrzahl von ersten Kanalgebieten vom ersten Leitfähigkeitstyp, welche von der ersten Hauptfläche her in die zweite Basisschicht hineinragen;
(f) eine Mehrzahl von Kathodenkurzschlussgebieten vom zweiten Leitfähigkeitstyp, welche von der ersten Hauptfläche her jeweils in die ersten Kanalgebiete eingelassen sind, wobei die ersten Kanalgebiete ausserhalb der Kathodenkurzschlussgebiete bis zur ersten Hauptfläche hochgeführt sind;
(g) erste Gateelektroden, welche oberhalb der ersten Hauptfläche jeweils über den hochgeführten ersten Kanalgebieten und vom Halbleitersubstrat isoliert angeordnet sind;
(h) einen Kathodenkontakt, welcher auf die erste Hauptfläche aufgebracht ist und die ersten Emittergebiete und die Kathodenkurzschlussgebiete kontaktiert; und
(i) einen Anodenkontakt, welcher auf die zweite Hauptfläche aufgebracht ist und die Emitterschicht kontaktiert.

Ein solches Bauelement ist z.B. aus der Druckschrift EP-A1-0 340 445 bekannt.

### STAND DER TECHNIK

Seit einigen Jahren ist in der Leistungselektronik zunehmend die Entwicklung von MOS-gesteuerten Bauelementen vorangetrieben worden. Eingeleitet wurde dieser Trend von den unipolaren Leistungs-MOSFETs mit DMOS-Struktur.

Der Vorteil dieser MOS-gesteuerten Bauelemente liegt hauptsächlich in der hohen Eingangsimpedanz an der Steuerelektrode begründet. Sie ermöglicht die Ansteuerung des Bauelements mit einem vergleichsweise sehr geringen Aufwand an Leistung.

Die DMOSFETs haben jedoch einen gewichtigen Nachteil: Hohe Durchbruchspannungen müssen bei diesen Bauelementen wegen des unipolaren Leitungscharakters mit hohen Durchlasswiderständen erkauft werden, welche die maximale Stromstärke begrenzen.

Seit kurzer Zeit ist für dieses Problem mit dem IGBT (Insulated Gate Bipolar Transistor) eine Lösung verfügbar (siehe dazu: B.J. Baliga et al., IEEE Trans. Electron Devices, ED-31, S. 821-828 (1984)).

Der IGBT verfügt über eine Kathodenstruktur, die der des DMOSFET weitgehend ähnelt. Er kann vereinfacht als eine Kaskadenschaltung aus einem DMOSFET und einem Bipolar-Transistor aufgefasst werden. Infolge des bipolaren Stromtransports in der hochohmigen n-Basisschicht ist dieser Bereich leitfähigkeitsmoduliert; damit kann auch bei Bauelementen mit hoher Sperrspannung ein kleiner Wert für den Durchlasswiderstand realisiert werden.

Es ist nun weiterhin vorgeschlagen worden, das beschriebene Konzept der Steuerung von Leistungshalbleiter-Bauelementen über MOS-Gates auch bei Bauelementen der höchsten Leistungsklasse, nämlich bei Thyristoren, zu verwirklichen (siehe dazu den Artikel von V.A.K. Temple, IEEE Trans. Electron Devices, ED-33, S. 1609-1618 (1986)).

Bei einem derartigen MOS-gesteuerten Thyristor oder MCT (MOS Controlled Thyristor), der aus einer Vielzahl von nebeneinanderliegenden, parallelgeschalteten Einheitszellen besteht, wird das Abschalten über einen Kurzschluss des Emitters mit der p-Basis durch schaltbare Emittershorts erreicht. Als Schalter dienen dabei mit dem Emitter integrierte MOSFETs, die naturgemäss wahlweise als n-oder p-Kanal-MOSFETs ausgebildet sein können.

Ein Besipiel für eine derartige Struktur wird in der Europäischen Patentanmeldung EP 0 219 995 A2 angegeben. Es werden zwei nebeneinander liegende MOSFETs Q1 und Q2 verwendet, von denen der eine als Einschalt-MOSFET und der andere als Ausschalt-MOSFET dient.

Im Hinblick auf eine einfache Schaltungstechnik ist es natürlich wünschenswert, mit Hilfe der MOS-Gates den Thyristor nicht nur aus- sondern auch einzuschalten. Dies sollte nach Möglichkeit mit einer einzigen Steuerelektrode erreichbar sein.

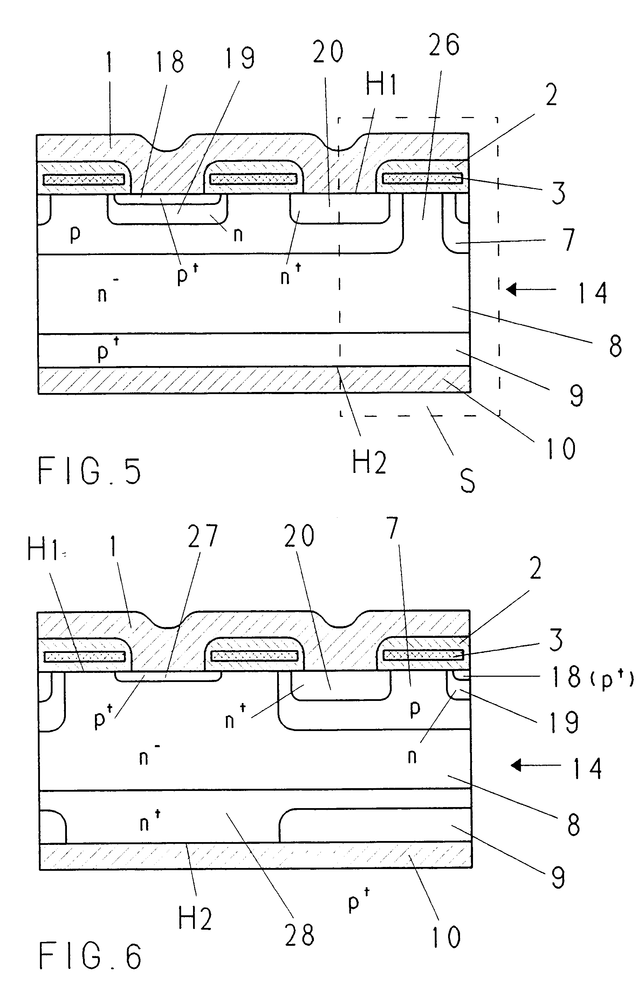

Eine Struktur, welche diese Anforderungen erfüllt, ist in dem genannten Artikel von V.A K. Temple bereits vorgeschlagen worden (dortige Fig. 5). Es handelt sich dabei um eine kombinierte Ein- und Ausschaltzelle, bei der innerhalb der ursprünglichen MCT-Einheitszelle eine weitere DMOS-Struktur benutzt wird, um über einen Kanal in der zur Substratoberfläche hochgezogenen p-Basisschicht Elektronen in die n-Basisschicht zu injizieren.

Diese bekannte kombinierte Ein- und Ausschaltzelle wirft jedoch zwei Probleme auf:

Der Kanal des zum Einschalten verwendeten DMOSFET wird von der an die Oberfläche gezogenen p-Basisschicht gebildet. Für typische Thyristoren bewegt sich die Tiefe dieser p-Basisschicht im Bereich von wenigstens 20 Mikrometern. Dieses Mass entspricht dann auch in etwa der Kanallänge des DMOSFET. Es ist damit erheblich grösser als die typischen Kanallängen von IGBTs, welche bei ungefähr 1 Mikrometer liegen. Wegen der grossen Kanallänge werden weniger Elektronen in die n-Basisschicht injiziert, wodurch beim Einschalten der effiziente Aufbau eines Plasmas behindert und die Einschaltzeit verlängert wird.

Andererseits hat die Verwendung von kombinierten Ein- und Ausschaltzellen zur Folge, dass höchstens genausoviele Einschalt- wie Ausschaltelemente im Bauelement vorhanden sind. Es fehlt daher die Möglichkeit, Anzahl und Verteilung dieser Elemente unabhängig voneinander im Hinblick auf die an das Bauelement gestellten Anforderungen zu optimieren.

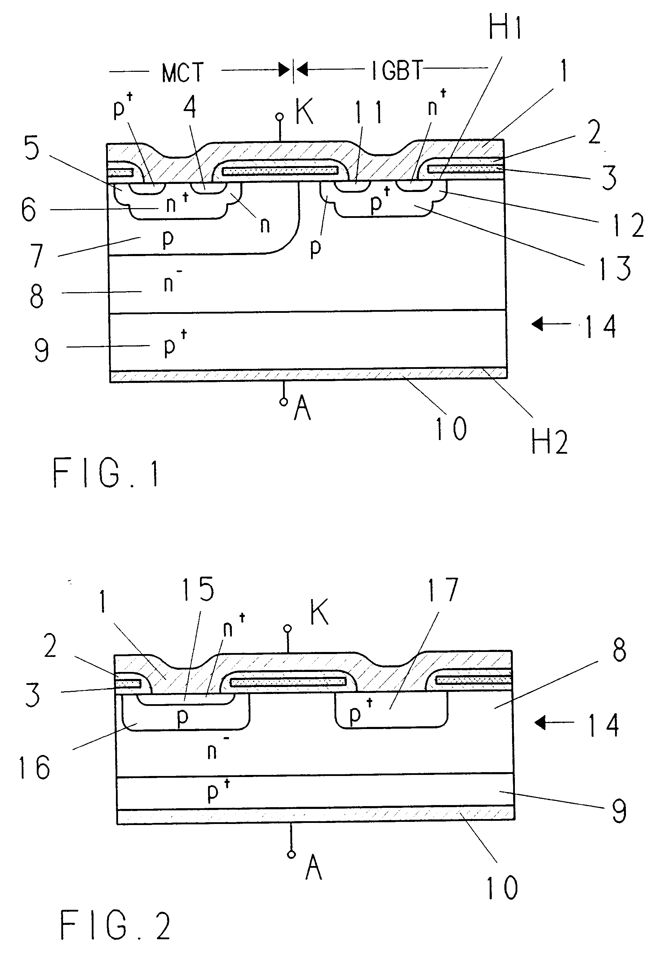

Um diesen Problemen abzuhelfen, ist in der eingangs genannten Druckschrift EP-A1-0 340 445 vorgeschlagen worden, bei einem MCT die bekannten kombinierten Ein- und Ausschaltzellen durch zwei getrennte, parallelgeschaltete MCT- und IGBT-Einheitszellen zu ersetzen (Fig. 1).

Für die Herstellung eines solchen Bauelements ist allerdings ein Prozess mit wenigstens 13 Maskenebenen erforderlich. Darüberhinaus ist es notwendig, eine Lithographie zu verwenden, die mit sehr hoher Präzision arbeitet. Alle diese Bedingungen führen zu einer komplexen Produktion mit hohen Produktionskosten und - als spezifisches Charakteristikum der Silizium-Technologie - zu einer vergleichsweise geringen Ausbeute an Bauelementen.

Um diesen Schwierigkeiten auszuweichen, ist daher weiterhin ein vereinfachtes Bauelement vorgeschlagen worden (siehe dazu: Patent Abstracts of Japan, Band 13, Nr. 150 (E-742) [3498], 12. April 1989; oder: ältere Deutsche Patentanmeldung Nr. P 40 24 526.8), bei welchem zwei unterschiedliche Einheitszellen alternierend nebeneinander angeordnet sind. Die eine der beiden Einheitszellen weist eine p-n-p-Dreischichtstruktur, die andere eine p-n-p-n-Vierschichtstruktur auf (Fig. 2).

Nachteil dieses vereinfachten Bauelements ist allerdings eine vergleichsweise geringe maximale Sperrspannung bis zu etwa 1 kV. Für Anwendungen, in denen höchste Spannungsfestigkeit der Bauelemente bis in den Bereich von mehreren kV verlangt wird, kommen sie daher nicht in Betracht.

### DARSTELLUNG DER ERFINDUNG

Aufgabe der vorliegenden Erfindung ist es nun, ein Leistungshalbleiter-Bauelement anzugeben, welches über ein einziges MOS-Gate an- und abgeschaltet werden kann, welches aufgrund eines vereinfachten Aufbaus mit vergleichsweise wenigen Schritten hergestellt werden kann, und welches hinsichtlich der Spannungsfestigkeit auch höchsten Anforderungen genügt.

Die Aufgabe wird bei einem Bauelement der eingangs genannten Art dadurch gelöst, dass
(k) die ersten Emittergebiete und die ersten Kanalgebiete durch die zweite Basisschicht voneinander getrennt und lateral nebeneinander angeordnet sind und in die zweite Basisschicht hineinragen, wobei jedes erste Emittergebiet und jedes erste Kanalgebiet mit dem darin eingelassenen Kathodenkurzschlussgebiet zusammen mit den darunterliegenden Schichten eine Emitterzelle bzw. eine DMOS-Zelle bilden, welche Zellen nebeneinander angeordnet und elektrisch parallelgeschaltet sind.

Der Kern der Erfindung besteht darin, anstelle der bekannten MCT-Einheitszelle, in welcher der kathodenseitige Emitter und der MOS-gesteuerte Kathodenkurzschluss zu einer komplexen, schwer herstellbaren Struktur zusammengefasst sind, einzelne Zellen nebeneinander anzuordnen, die entweder einen Emitter (im Fall der Emitterzelle) oder einen MOS-gesteuerten Kurzschluss (im Fall der DMOS-Zelle), nicht aber beides zusammen enthalten.

Das Bauelement gemäss der Erfindung hat neben den Vorteilen der erhöhten Spannungsfestigkeit und der einfachen Herstellbarkeit noch den Vorteil einer grösseren Flexibilität bei der Auslegung der elektrischen Kennwerte, weil je nach Bedarf unterschiedliche Anzahlen von Emitterzellen und DMOS-Zellen miteinander kombiniert werden können.

Eine erste bevorzugte Ausführungsform des Bauelements nach der Erfindung zeichnet sich dadurch aus, dass
(a) zusätzlich zu den Emitterzellen und den DMOS-Zellen Einschaltzellen vorgesehen sind, welche zwischen den Emitterzellen und DMOS-Zellen angeordnet und zu diesen parallelgeschaltet sind, wobei jede Einschaltzelle an wenigstens eine benachbarte Emitterzelle angrenzt;
(b) innerhalb jeder Einschaltzelle nacheinander die zweite Basisschicht und in einer Unterbrechung der zweiten Basisschicht die erste Basisschicht zur ersten Hauptfläche hochgeführt sind, wobei die erste Basisschicht ein von der zweiten Basisschicht umgebenes Einschaltgebiet bildet; und
(c) innerhalb jeder Einschaltzelle die erste Gateelektrode auch die zwischen dem Einschaltgebiet und dem ersten Emittergebiet der benachbarten Emitterzelle hochgeführte zweite Basisschicht überdeckt.

Hierdurch wird auf einfache Weise die Einschaltfunktion des Bauelements nach der Erfindung sichergestellt.

Weitere vorteilhafte Ausführungsformen der Erfindung ergeben sich aus den Unteransprüchen.

### KURZE BESCHREIBUNG DER ZEICHNUNG

Die Erfindung soll nachfolgend im Zusammenhang mit der Zeichnung anhand von Ausführungsbeispielen näher erläutert werden. Es zeigen
- Fig. 1: im Querschnitt die Einheitszellen eines ersten MOS-gesteuerten bipolaren Leistungshalbleiter-Bauelements nach dem Stand der Technik mit vergleichsweise komplexer innerer Struktur;
- Fig. 2: im Querschnitt die Einheitszellen eines zweiten, vereinfachten, MOS-gesteuerten bipolaren Leistungshalbleiter-Bauelements nach dem Stand der Technik;
- Fig. 3: im Querschnitt die Einheitszellen eines ersten bevorzugten Ausführungsbeispiels für ein Leistungshalbleiter-Bauelement nach der Erfindung mit getrennten Emitterzellen (E) und DMOS-Zellen (D);
- Fig. 4: ein zweites bevorzugtes Ausführungsbeispiel für ein Leistungshalbleiter-Bauelement nach der Erfindung mit zusätzlichen MOS-gesteuerten Kurzschlüssen auf der Anodenseite;
- Fig. 5: ein drittes bevorzugtes Ausführungsbeispiel für ein Leistungshalbleiter-Bauelement nach der Erfindung mit zusätzlichen Einschaltzellen (S) zwischen den Emitter- und DMOS-Zellen;
- Fig. 6: ein viertes bevorzugtes Ausführungsbeispiel für ein Leistungshalbleiter-Bauelement nach der Erfindung mit integrierter Inversdiode;
- Fig. 7: eine erste beispielhafte Anordnung einer gleichen Anzahl von Emitter- und DMOS-Zellen mit zwischengeschaltetem Einschaltstreifen bei einem Bauelement nach der Erfindung;
- Fig. 8: eine von Fig. 7 abweichende, beispielhafte Zellenanordnung mit einer Ueberzahl an DMOS-Zellen;
- Fig. 9: eine Fig. 7 entsprechende Anordnung mit hexagonalen Emitter- und DMOS-Zellen;
- Fig. 10: eine Fig. 8 entsprechende Anordnung mit hexagonalen Emitter- und DMOS-Zellen; und
- Fig. 11: eine gemischte Anordnung aus dreieckigen DMOS-Zellen und hexagonalen Emitterzellen.

### WEGE ZUR AUSFÜHRUNG DER ERFINDUNG

Um einen besseren Vergleich mit dem erfindungsgemässen Bauelement zu ermöglichen, sei zunächst anhand der Fig. 1 und 2 noch einmal der Stand der Technik bei den MCTs erläutert.

Fig. 1 zeigt die beiden verschiedenen Einheitszellen eines MOS-gesteuerten Thyristors, wie er aus der eingangs genannten Druckschrift EP-A1-0 340 445 bekannt ist. Innerhalb eines grossflächigen, scheibenförmigen Halbleitersubstrats 14, welches oben (auf der Seite der Kathode K) durch eine erste Hauptfläche H1 und unten (auf der Seite der Anode A) durch eine zweite Hauptfläche H2 begrenzt ist, sind alternierend IGBT-Zellen (rechter Teil) und MCT-Zellen (linker Teil) angeordnet. Allen Zellen gemeinsam ist eine durchgehende erste Basisschicht 8, die vom n⁻-dotierten Grundmaterial des Halbleitersubstrats 14 gebildet wird, und eine anodenseitige, p⁺-dotierte Emitterschicht 9.

Die IGBT-Zellen, die zum Einschalten des Bauelements vorgesehen sind, umfassen neben der ersten Basisschicht 8 und der Emitterschicht 9 jeweils ein p⁺-dotiertes Kollektorgebiet 13, ein p-dotiertes Kanalgebiet 12 und n⁺-dotierte Sourcegebiete 11. Ueber dem Kanalgebiet 12 ist isoliert eine Gateelektrode 3 angeordnet, die bei geeigneter Vorspannung in dem Kanalgebiet 12 einen n-Kanal erzeugt, über den Elektronen in die erste Basisschicht 8 fliessen und eine Löcherinjektion aus der Emitterschicht 9 hervorrufen können.

Bei den MCT-Zellen (den Abschaltzellen) ragen von der ersten Hauptfläche H1 her n⁺-dotierte Emittergebiete 7 und n-dotierte Kanalgebiete 5 in eine zweite, p-dotierte Basisschicht 7 hinein. In die Kanalgebiete 5 wiederum sind von der ersten Hauptfläche H1 her p⁺-dotierte Kathodenkurzschlussgebiete 4 eingelassen, die durch die zur ersten Hauptfläche H1 hochgezogenen Kanalgebiete 5 von der zweiten Basisschicht 7 getrennt sind. Die gemeinsame Gateelektrode 3 erstreckt sich auch über die hochgeführten Kanalgebiete 5.

Die Kathodenkurzschlussgebiete 4 und das Emittergebiet 6 der MCT-Zelle werden, ebenso wie die Sourcegebiete 11 und das Kollektorgebiet 13 der IGBT-Zelle, von einem Kathodenkontakt 1 in Form einer Metallisierung kontaktiert. Die Emitterschicht 9 ist entsprechend durch einen metallischen Anodenkontakt 10 bedeckt.

Durch Anlegen eines negativen Potentials (bezogen auf das Potential der Kathode K) an die Gateelektrode 3 wird der Thyristor der Fig. 1 durch die MCT-Zellen aus dem eingeschalteten Zustand in den vorwärtssperrenden Zustand überführt. Zur Verbesserung des Einschaltverhaltens werden zusätzlich die IGBT-Zellen vorgesehen.

Die andere bekannte Bauelementstruktur, auf die eingangs bereits verwiesen worden ist, zeichnet sich dadurch aus, dass, wie in Fig. 2 gezeigt, anstelle der komplizierten MCT- und IGBT-Zellen zwei vereinfachte Zellentypen parallelgeschaltet sind. Im einen Zellentyp (linker Teil der Fig. 2) ragen ein n⁺-dotiertes Emittergebiet 15 und ein p-dotiertes Basisgebiet ineinander verschachtelt in die erste Basisschicht 8 und bilden mit den darunterliegenden Schichten eine Vierschichtstruktur.

Im anderen Zellentyp (rechter Teil der Fig. 2) ist ein p⁺-dotiertes Kontaktgebiet 17 in die erste Basisschicht 8 eingelassen. Das an den Seiten hochgeführte Basisgebiet 16 und der zwischen Basisgebiet 16 und Kontaktgebiet 17 liegende Teil der ersten Basisschicht 8 sind von der Gateelektrode 3 überdeckt.

Obgleich das Bauelement aus Fig. 2 eine stark vereinfachte Struktur aufweist, genügt es, wie eingangs bereits erwähnt, höheren Anforderungen bezüglich der Sperrspannung nicht, sodass die weiteren Betrachtungen von einem Bauelement gemäss Fig. 1 ausgehen.

Die Abschaltzelle nach Fig. 1 besitzt eine parasitäre, vertikale p-n-p-Bipolarstruktur (Löcheremitter = zweite Basisschicht 7; Basis = Kanalgebiet 5; Löcherkollektor = Kathodenkurzschlussgebiet 4). Unabhängig von der Spannung an der Gateelektrode 3 kann dieser parasitäre Bipolartransistor die von der Anode A kommenden Löcher übernehmen. Findet dies statt, so fliesst eine grosse Zahl von Löchern über diesen parasitären Pfad in die Kathodenkurzschlussgebiete 4, also nicht über das eigentliche Emittergebiet 6 des Thyristors. Dieser reagiert darauf mit einer entsprechend geringeren Emission von Elektronen. Auf die elektrischen Eigenschaften des Thyristors übertragen bedeutet dies, dass ein solches Bauelement eine schlechte Durchlasskennlinie mit hohem ON-Widerstand, also auch hohen Leitungsverlusten hat.

Eine mögliche Massnahme zur Bekämpfung dieses unerwünschten Mechanismus besteht darin, die Fläche des parasitären Bipolartransistors möglichst klein zu machen. Das bedeutet, dass das Emittergebiet 6 optimal mit der Kante der Poly-Si-Gateelektrode 3 justiert werden muss, welche ihrerseits die laterale Position der Kanalgebiete 5 und der Kathodenkurzschlussgebiete 4 bestimmt. Ebenso sollten alle Diffusionen für die einzelnen Gebiete möglichst flach sein, um sehr grosse Krümmungsradien (und damit kleine aktive Basisflächen) zu erhalten. An diesen Anforderungen wird bereits deutlich, dass eine Abhilfe dieser Art nur durch sehr aufwendige und komplizierte Technologien (z.B. mittels eines Wafersteppers) verwirklicht werden kann.

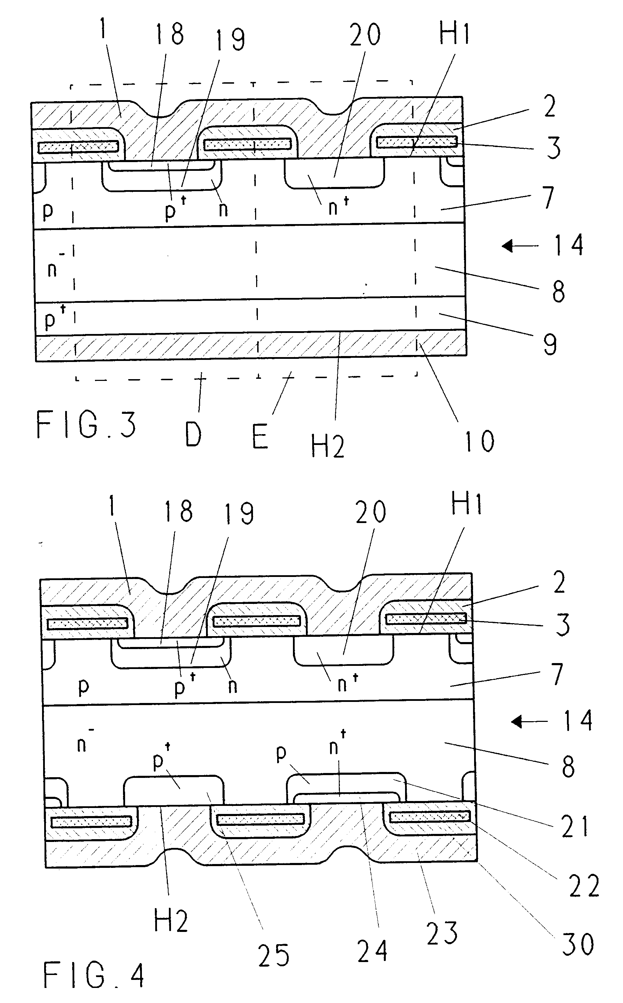

Einen anderen Weg geht hier nun die vorliegende Erfindung: Im Thyristorteil des Bauelements (entspricht der MCT-Zelle aus Fig. 1) werden die beiden nur schwer zu vereinbarenden Bestandteile, nämlich der kathodenseitige n⁺-Emitter und der MOS-gesteuerte Kurzschluss, voneinander getrennt in eigenständigen Einheitszellen untergebracht. Eine grundsätzliche Ausführungsform für diese Lösung ist in Fig. 3 wiedergegeben.

Das Halbleitersubstrat 14 umfasst auch in diesem Fall zwischen den beiden Hauptflächen H1 und H2 die durchgehende, n⁻-dotierte, erste Basisschicht 8, die durchgehende, p-dotierte, zweite Basisschicht 7 und die durchgehende, p⁺-dotierte Emitterschicht 9. Innerhalb des Halbleitersubstrats 14 werden nun zwei unterschiedliche Arten von Einheitszellen gebildet, eine Emitterzelle E und eine DMOS-Zelle D (in der Fig. 3 angedeutet durch strichlierte Rechtecke).

In der Emitterzelle E ist von der ersten Hauptfläche H1 her in die zweite Basisschicht 7 ein n⁺-dotiertes, erstes Emittergebiet 20 eingelassen, welches zusammen mit den darunterliegenden Schichten 7, 8 und 9 die Vierschichtstruktur eines Thyristors bildet. In der DMOS-Zelle D mit ihrer Fünfschichtstruktur ragt von der ersten Hauptfläche H1 her in die zweite Basisschicht 7 ein n-dotiertes erstes Kanalgebiet 19 hinein, in welches seinerseits ein p⁺-dotiertes Kathodenkurzschlussgebiet 18 eingelassen ist. Das erste Kanalgebiet 19 ist ausserhalb des Kathodenkurzschlussgebietes 18 zur ersten Hauptfläche H1 hochgezogen und dort von einer isolierten ersten Gateelektrode 3 überdeckt. Kathodenkurzschlussgebiet 18 und erstes Emittergebiet 20 werden direkt von dem Kathodenkontakt 1 kontaktiert.

Die Vierschichtstruktur der Emitterzellen E kann im Gegensatz zur Fünfschichtstruktur der DMOS-Zellen D einrasten. Mit einer negativen Spannung an der ersten Gateelektrode 3 werden beim Abschalten die p-Kanäle in den ersten Kanalgebieten 19 leitend: die Kathodenkurzschlussgebiete 18 sind dann direkt mit der zweiten Basisschicht 7 verbunden. In diesem Fall sind alle Emitterkurzschlüsse auf der Kathodenseite aktiviert. Bei einer hinreichend grossen Anzahl von aktivierten Kurzschlüssen kann der Thyristor den eingerasteten Zustand nicht mehr aufrechterhalten und das Bauelement schaltet ab.

Bei der Ausführungsform gemäss Fig. 3 ist nur die Kathodenseite des Bauelements strukturiert, d.h. in bestimmte Einheiten unterteilt, während die anodenseitige Emitterschicht 9 durchgehend angelegt ist. In einer Weiterbildung der Erfindung kann auch die Anodenseite des Bauelements strukturiert sein. Eine mögliche Ausführungsform eines derartigen Bauelements ist in Fig. 4 dargestellt.

Die Emitterschicht 9 ist hierbei in einzelne zweite Emittergebiete 25 aufgeteilt, die innerhalb der DMOS-Zelle D jeweils dem ersten Kanalgebiet 19 gegenüberliegen. Zwischen den zweiten Emittergebieten 25 und jeweils gegenüber einem ersten Emittergebiet 20 (d.h. innerhalb jeder Emitterzelle E) ragt von der zweiten Hauptfläche H2 her ein zweites p-dotiertes Kanalgebiet 21 in die erste Basisschicht 8 hinein.

In die zweiten Kanalgebiete 21 sind jeweils von der zweiten Hauptfläche H2 her n⁺-dotierte Anodenkurzschlussgebiete 24 eingelassen und von einem Anodenkontakt 23 kontaktiert. Die zweiten Kanalgebiete 21 sind dabei ausserhalb der Anodenkurzschlussgebiete 24 bis zur zweiten Hauptfläche H2 hochgeführt und werden dort von zweiten Gateelektroden 22 überdeckt, welche oberhalb der zweiten Hauptfläche H2 vom Halbleitersubstrat 14 isoliert angeordnet sind.

Alle bisherigen Ausführungen zu dem Bauelement nach der Erfindung haben sich auf das Ausschalten beschränkt. Die zusätzliche Funktion des Einschaltens ist dabei nicht berücksichtigt worden. Sie kann bei der in Fig. 3 wiedergegebenen Struktur mit dem gleichen MOS-Gate ohne die Anwendung weiterer Maskenschritte bei der Herstellung realisiert werden. Die dazu notwendige Modifikation der Bauelementstruktur ist in Fig. 5 gezeigt.

Bei der Ausführungsform gemäss Fig. 5 sind innerhalb des Halbleitersubstrats 14 zusätzlich zu den Emitterzellen E und den DMOS-Zellen D sogenannte Einschaltzellen S vorgesehen, welche zwischen den Emitterzellen E und DMOS-Zellen D angeordnet und zu diesen parallelgeschaltet sind (in Fig. 5 angedeutet durch ein strichliertes Rechteck).

Jede Einschaltzelle S grenzt dabei an wenigstens eine benachbarte Emitterzelle E an.

Innerhalb jeder Einschaltzelle S sind nacheinander die zweite Basisschicht 7 und in einer Unterbrechung der zweiten Basisschicht 7 die erste Basisschicht 8 zur ersten Hauptfläche H1 hochgeführt, wobei die erste Basisschicht 8 ein von der zweiten Basisschicht 7 umgebenes Einschaltgebiet 26 bildet. Ausserdem überdeckt innerhalb jeder Einschaltzelle S die erste Gateelektrode 3 auch die zwischen dem Einschaltgebiet 26 und dem ersten Emittergebiet 20 der benachbarten Emitterzelle E hochgeführte zweite Basisschicht 7.

Die Oberfläche der hochgeführten zweiten Basisschicht 7 kann durch ein positives Signal an der ersten Gateelektrode 3 invertiert und damit für Elektronen leitend gemacht werden. Diese Elektronen strömen von dem ersten Emittergebiet 20 der benachbarten Emitterzelle E durch die Inversions-Kanäle in das Einschaltgebiet der ersten Basisschicht 8 und führen dort zur Zündung des Bauelements. Die Höhe des Zündstromes kann dabei über die Dichte der Einschaltzellen S eingestellt werden.

Vergleicht man nun die neue Struktur aus Fig. 5 mit der bekannten Struktur aus Fig. 1, welche die gleichen elektrischen Funktionen besitzt, so ist unmittelbar ersichtlich, dass das neue Bauelement unter Einsparung von drei Maskenschritten hergestellt werden kann. Das bedeutet insbesondere für die grossflächigen Bauelemente wie Thyristoren, dass die Ausbeute erhöht werden kann. Der besondere Vorteil des Bauelements nach Fig. 5 liegt einerseits in dem sehr einfachen Herstellungsprozess und zum anderen in dem sehr niedrigen ON-Widerstand. Die vorgeschlagene Struktur ist damit für solche Anwendungen interessant, in denen eine hohe Stromtragfähigkeit (erzielt durch Bauelemente mit grossen Flächen) und gleichzeitig niedrige statische Verluste gefordert sind.

Gemäss einer anderen Weiterbildung der Erfindung kann in eine Struktur nach Fig. 3 zusätzlich eine Invers- bzw. Freilaufdiode integriert werden. Eine Ausführungsform für ein solches kombiniertes Bauelement ist in Fig. 6 wiedergegeben.

Bei dem Bauelement aus Fig. 6 ist in dem Halbleitersubstrat 14 zwischen der ersten Basisschicht 8 und der Emitterschicht 9 eine n⁺-dotierte, durchgehende Zwischenschicht 28 angeordnet. In vorbestimmten Bereichen ist die zweite Basisschicht 7 unterbrochen und die erste Basisschicht 8 dort bis zur ersten Hauptfläche H1 hochgeführt. Weiterhin ist in diesen vorbestimmten Bereichen auch die Emitterschicht 9 unterbrochen und die Zwischenschicht 28 zur zweiten Hauptfläche H2 hochgeführt. Schliesslich ragt in diesen vorbestimmten Bereichen jeweils ein p⁺-dotiertes Extraktionsgebiet 27 von der ersten Hauptfläche H1 her in die erste Basisschicht 8 hinein und wird von dem Kathodenkontakt 1 kontaktiert. Die Abfolge von Extraktionsgebiet 27, erster Basisschicht 8 und Zwischenschicht 28 bildet eine Diode, die zu den übrigen Zellen antiparallel geschaltet ist.

Es sei an dieser Stelle darauf hingewiesen, dass zur Herstellung eines Bauelements gemäss den Fig. 3 - 6 selbstjustierende Verfahren für die Lithographie verwendet werden können, wie sie in der eingangs genannten Deutschen Patentanmeldung mit dem Aktenzeichen P 40 24 526.8 beschrieben sind.

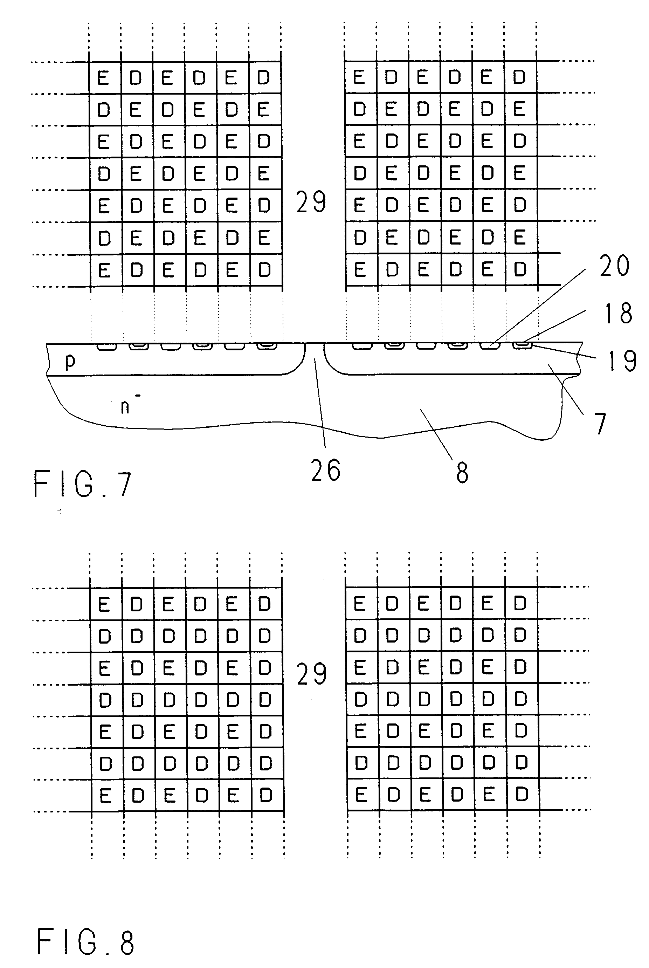

Bisher war nur von Emitterzellen E, DMOS-Zellen D und Einschaltzellen S (die man auch als IGBT-Zellen bezeichnen kann) die Rede. Grundsätzlich können diese verschiedenen Elementarzellen beliebig kombiniert werden, um so die gewünschten Bauelementeigenschaften zu erzielen. Neben einer Realisierung des Bauelements mit quadratischen oder rechteckigen Elementarzellen kann zumindest ein Teil der Emitterzellen E, DMOS-Zellen D und Einschaltzellen S als langgestreckte Streifen ausgebildet sein. Desweiteren können auch quadratische Zellen und Streifen gemischt verwendet werden. Zwei Ausführungsbeispiele für eine solche gemischte Realisierung, bei der speziell die Einschaltzellen S als Einschaltstreifen ausgebildet sind, sind in den Fig. 7 und 8 dargestellt.

Fig. 7 zeigt im oberen Teil in der Draufsicht von der Kathodenseite her ein alternierendes Muster von quadratischen Emitterzellen E und DMOS-Zellen D, welches zwischendrin durch einen Einschaltstreifen 29 unterbrochen wird. Im unteren Teil der Figur ist ausschnittweise der zugehörige Querschnitt durch das Bauelement wiedergegeben. Zu dieser Ausführungsform ist zu bemerken, dass hier DMOS-Zellen D und Emitterzellen E in gleicher Anzahl vorhanden sind.

Bei der Bauelementstruktur nach der Erfindung (Fig. 4) hängt die Abschaltfähigkeit vom Verhältnis der Anzahl der DMOS-Zellen D zu der Anzahl der Emitterzellen E ab. Wegen der gegenüber der bekannten Struktur aus Fig. 1 grundsätzlich grösseren Entfernung der Kanäle muss hier ein gewisser Verlust an Abschaltvermögen in Kauf genommen werden. Dieser Verlust kann in gewissen Grenzen ausgeglichen werden, indem eine grössere Anzahl von DMOS-Zellen D mit einer kleineren Anzahl von Emitterzellen E kombiniert werden. Ein Ausführungsbeispiel für diese Art der Struktur ist in Fig. 8 dargestellt. Es sei dazu angemerkt, dass in diesem Fall bezüglich der Anzahl der DMOS-Zellen D pro Emitterzelle E nach oben hin keine Grenzen bestehen.

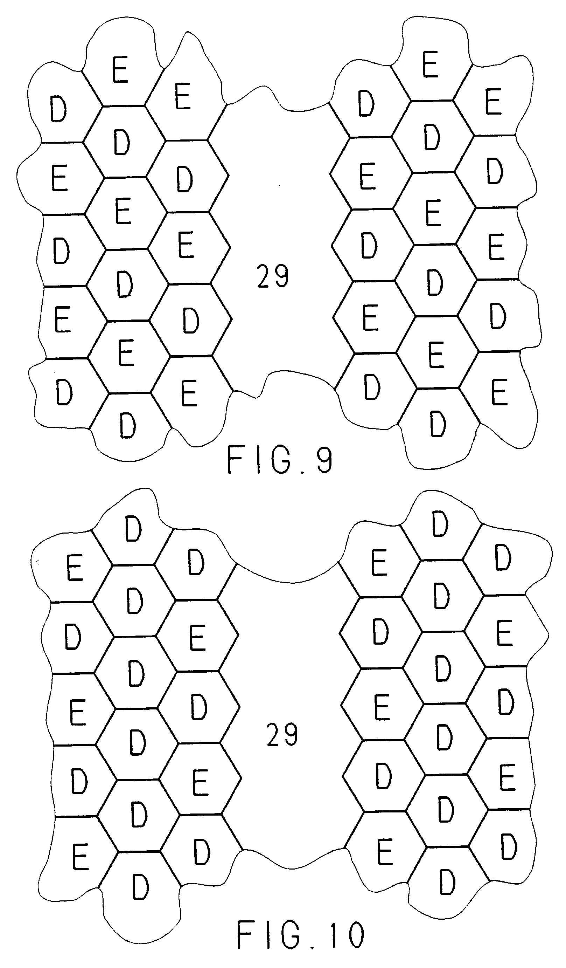

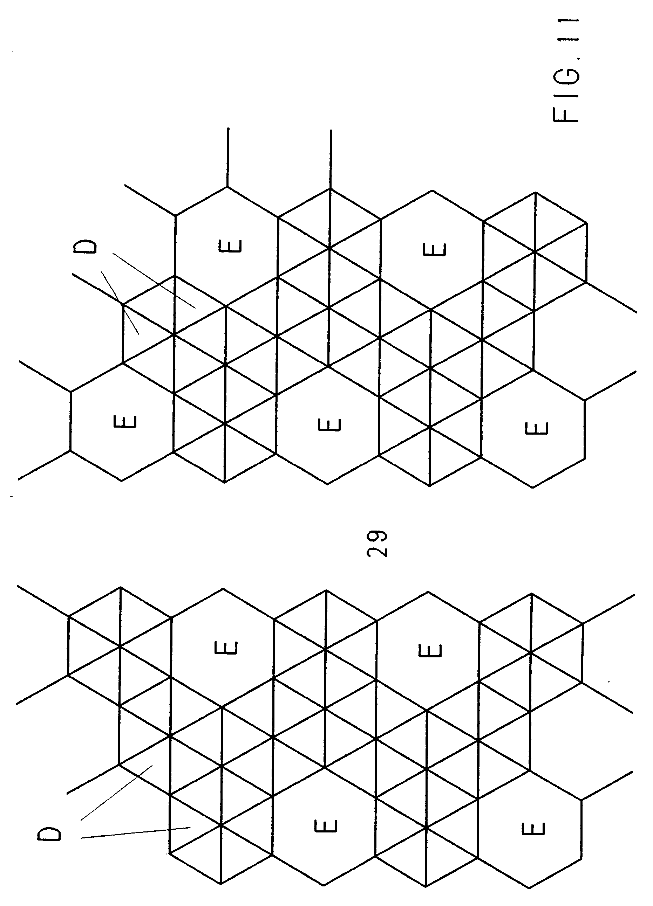

Anstelle der bisher beschriebenen rechteckigen Zellen können im Rahmen der Erfindung selbstverständlich auch andere Zellengeometrien verwendet werden. So ist in Fig. 9 eine Fig. 7 entsprechende Anordnung mit einer gleichen Zahl von Emitterzellen E und DMOS-Zellen D dargestellt, wobei die einzelnen Zellen jeweils eine hexagonale Geometrie aufweisen. Entsprechend zu Fig. 8 zeigt Fig. 10 eine Ausführungsform mit hexagonaler Zellengeometrie, bei der die Anzahl der DMOS-Zellen D überwiegt. Fig. 11 gibt schliesslich im Ausschnitt ein Bauelement wieder, bei welchem dreieckige DMOS-Zellen D mit hexagonalen Emitterzellen E kombiniert sind.

Zum Schluss sei noch darauf hingewiesen, dass die beschriebenen Strukturen statt mit den hier gezeigten auch mit den komplementären Leitungstypen und Dotierungen für die einzelnen Schichten und Gebiete realisiert werden können.

## Patentansprüche

1. Abschaltbares, MOS-gesteuertes Leistungshalbleiter-Bauelement, umfassend
(a) ein Halbleitersubstrat (14) von einem ersten Leitfähigkeitstyp, welches Halbleitersubstrat (14) auf der einen Seite durch eine erste Hauptfläche (H1) und auf der anderen Seite durch eine zweite Hauptfläche (H2) begrenzt wird und in seinem Inneren eine erste Basisschicht (8) bildet;
(b) eine Emitterschicht (9) von einem zweiten, zum ersten entgegengesetzten Leitfähigkeitstyp, welche Emitterschicht (9) von der zweiten Hauptfläche (H2) her in die erste Basisschicht (8) hineinragt;
(c) eine zweite Basisschicht (7) vom zweiten Leitfähigkeitstyp, welche zweite Basisschicht (7) von der ersten Hauptfläche (H1) her in die erste Basisschicht (8) hineinragt;
(d) eine Mehrzahl von ersten Emittergebieten (20) vom ersten Leitfähigkeitstyp, welche von der ersten Hauptfläche (H1) her in die zweite Basisschicht (7) hineinragen;
(e) eine Mehrzahl von ersten Kanalgebieten (19) vom ersten Leitfähigkeitstyp, welche von der ersten Hauptfläche (H1) her in die zweite Basisschicht (7) hineinragen;
(f) eine Mehrzahl von Kathodenkurzschlussgebieten (18) vom zweiten Leitfähigkeitstyp, welche von der ersten Hauptfläche (H1) her jeweils in die ersten Kanalgebiete (19) eingelassen sind, wobei die ersten Kanalgebiete (19) ausserhalb der Kathodenkurzschlussgebiete (18) bis zur ersten Hauptfläche (H1) hochgeführt sind;
(g) erste Gateelektroden (3), welche oberhalb der ersten Hauptfläche (H1) jeweils über den hochgeführten ersten Kanalgebieten (19) und vom Halbleitersubstrat (14) isoliert angeordnet sind;
(h) einen Kathodenkontakt (1), welcher auf die erste Hauptfläche (H1) aufgebracht ist und die ersten Emittergebiete (20) und die Kathodenkurzschlussgebiete (18) kontaktiert; und
(i) einen Anodenkontakt (10), welcher auf die zweite Hauptfläche (H2) aufgebracht ist und die Emitterschicht (9) kontaktiert;
dadurch gekennzeichnet, dass
(k) die ersten Emittergebiete (20) und die ersten Kanalgebiete (19) durch die zweite Basisschicht (7) voneinander getrennt und lateral nebeneinander angeordnet sind und in die zweite Basisschicht (7) hineinragen, wobei jedes erste Emittergebiet (20) und jedes erste Kanalgebiet (19) mit dem darin eingelassenen Kathodenkurzschlussgebiet (18) zusammen mit den darunterliegenden Schichten (7,8,9) eine Emitterzelle (E) bzw. eine DMOS-Zelle (D) bilden, welche Zellen nebeneinander angeordnet und elektrisch parallelgeschaltet sind.

2. Leistungshalbleiter-Bauelement nach Anspruch 1, dadurch gekennzeichnet, dass
(a) zusätzlich zu den Emitterzellen (E) und den DMOS-Zellen (D) Einschaltzellen (S) vorgesehen sind, welche zwischen den Emitterzellen (E) und DMOS-Zellen (D) angeordnet und zu diesen parallelgeschaltet sind, wobei jede Einschaltzelle (S) an wenigstens eine benachbarte Emitterzelle (E) angrenzt;
(b) innerhalb jeder Einschaltzelle (S) nacheinander die zweite Basisschicht (7) und in einer Unterbrechung der zweiten Basisschicht (7) die erste Basisschicht (8) zur ersten Hauptfläche (H1) hochgeführt sind, wobei die erste Basisschicht (8) ein von der zweiten Basisschicht (7) umgebenes Einschaltgebiet (26) bildet; und
(c) innerhalb jeder Einschaltzelle (S) die erste Gateelektrode (3) auch die zwischen dem Einschaltgebiet (26) und dem ersten Emittergebiet (20) der benachbarten Emitterzelle (E) hochgeführte zweite Basisschicht (7) überdeckt.

3. Leistungshalbleiter-Bauelement nach Anspruch 2, dadurch gekennzeichnet, dass zumindest ein Teil der Emitterzellen (E), DMOS-Zellen (D) und Einschaltzellen (S) als Streifen ausgebildet sind.

4. Leistungshalbleiter-Bauelement nach Anspruch 3, dadurch gekennzeichnet, dass speziell die Einschaltzellen (S) als Einschaltstreifen (29) ausgebildet sind.

5. Leistungshalbleiter-Bauelement nach Anspruch 1, dadurch gekennzeichnet, dass die Anzahl der DMOS-Zellen (D) grösser oder gleich der Anzahl der Emitterzellen (E) ist.

6. Leistungshalbleiter-Bauelement nach Anspruch 1, dadurch gekennzeichnet, dass
(a) die Emitterschicht (9) in einzelne zweite Emittergebiete (25) aufgeteilt ist, welche jeweils einem Kathodenkurzschlussgebiet (18) gegenüberliegen;
(b) zwischen den zweiten Emittergebieten (25) und jeweils gegenüber einem ersten Emittergebiet (20) von der zweiten Hauptfläche (H2) her ein zweites Kanalgebiet (21) vom zweiten Leitfähigkeitstyp in die erste Basisschicht (8) hineinragt;
(c) Anodenkurzschlussgebiete (24) des ersten Leitfähigkeitstyps von der zweiten Hauptfläche (H2) her jeweils in die zweiten Kanalgebiete (21) eingelassen sind und von dem Anodenkontakt (23) kontaktiert werden, wobei die zweiten Kanalgebiete (21) ausserhalb der Anodenkurzschlussgebiete (24) bis zur zweiten Hauptfläche (H2) hochgeführt sind; und
(d) zweite Gateelektroden (22) vorgesehen sind, welche oberhalb der zweiten Hauptfläche (H2) über den hochgeführten zweiten Kanalgebieten (21) und vom Halbleitersubstrat (14) isoliert angeordnet sind.

7. Leistungshalbleiter-Bauelement nach Anspruch 1, dadurch gekennzeichnet, dass
(a) zwischen der ersten Basisschicht (8) und der Emitterschicht (9) eine durchgehende Zwischenschicht (28) vom ersten Leitfähigkeitstyp angeordnet ist;
(b) in vorbestimmten Bereichen die zweite Basisschicht (7) unterbrochen und die erste Basisschicht (8) dort bis zur ersten Hauptfläche (H1) hochgeführt ist;
(c) in diesen vorbestimmten Bereichen die Emitterschicht (9) unterbrochen und die Zwischenschicht (28) zur zweiten Hauptfläche (H2) hochgeführt ist; und
(d) in diesen vorbestimmten Bereichen jeweils ein Extraktionsgebiet (27) des zweiten Leitfähigkeitstyps von der ersten Hauptfläche (H1) her in die erste Basisschicht (8) hineinragt und von dem Kathodenkontakt (1) kontaktiert wird.

8. Leistungshalbleiter-Bauelement nach einem der Ansprüche 1 bis 7, dadurch gekennzeichnet, dass der erste Leitfähigkeitstyp der n-Typ und der zweite Leitfähigkeitstyp der p-Typ ist.

9. Leistungshalbleiter-Bauelement nach Anspruch 8, dadurch gekennzeichnet, dass die erste Basisschicht (8) n⁻-dotiert, die zweite Basisschicht (7) p-dotiert, die Emitterschicht (9) und die Kathodenkurzschlussgebiete (18) p⁺-dotiert, die ersten Kanalgebiete (19) n-dotiert und die ersten Emittergebiete (20) n⁺-dotiert sind.

## Claims

1. Turn-off, MOS-controlled power semiconductor component comprising
(a) a semiconductor substrate (14) of a first conductivity type, which semiconductor substrate (14) is bounded on one side by a first principal face (H1) and on the other side by a second principal face (H2) and forms a first base layer (8) in its interior;
(b) an emitter layer (9) of a second conductivity type opposite to the first, which emitter layer (9) projects from the second principal face (H2) into the first base layer (8);
(c) a second base layer (7) of the second conductivity type, which second base layer (7) projects from the first principal face (H1) into the first base layer (8);
(d) a plurality of first emitter regions (20) of the first conductivity type, which project from the first principal face (H1) into the second base layer (7);
(e) a plurality of first channel regions (19) of the first conductivity type, which project from the first principal face (H1) into the second base layer (7);
(f) a plurality of cathode short-circuit regions (18) of the second conductivity type, which are let into the first channel regions (19) from the first principal face (H1) in each case, the first channel regions (19) being led up outside the cathode short-circuit regions (18) to the first principal face (H1);
(g) first gate electrodes (3), which are arranged above the first principal face (H1) over the led-up first channel regions (19) in each case and insulated from the semiconductor substrate (14);
(h) a cathode contact (1) which is applied to the first principal face (H1) and contacts the first emitter regions (20) and the cathode short-circuit regions (18); and
(i) an anode contact (10) which is applied to the second principal face (H2) and contacts the emitter layer (9);
characterized in that
(k) the first emitter regions (20) and the first channel regions (19) are separated from one another by the second base layer (7) and are arranged laterally next to one another and project into the second base layer (7), each first emitter region (20) and each first channel region (19) with the cathode short-circuit region (18) let into the latter forming together with the layers (7, 8, 9) located therebelow an emitter cell (E) or a DMOS cell (D), which cells are arranged next to one another and are connected in parallel electrically.

2. Power semiconductor component according to Claim 1, characterized in that
(a) in addition to the emitter cells (E) and the DMOS cells (D), turn-on cells (S) are provided which are arranged between the emitter cells (E) and DMOS cells (D) and are connected in parallel thereto, each turn-on cell (S) adjoining at least one adjacent emitter cell (E);
(b) inside each turn-on cell (S), the second base layer (7) and, in an interruption of the second base layer (7), the first base layer (8) are led up one after another to the first principal face (H1), the first base layer (8) forming a turn-on region (26) surrounded by the second base layer (7); and
(c) inside each turn-on cell (S), the first gate electrode (3) also covers the second base layer (7), which is led up between the turn-on region (26) and the first emitter region (20) of the adjacent emitter cell (E).

3. Power semiconductor component according to Claim 2, characterized in that at least a portion of the emitter cells (E), DMOS cells (D) and turn-on cells (S) are constructed as strips.

4. Power semiconductor component according to Claim 3, characterized in that the turn-on cells (S) are specifically constructed as turn-on strips (29).

5. Power semiconductor component according to Claim 1, characterized in that the number of the DMOS cells (D) is greater than or equal to the number of the emitter cells (E).

6. Power semiconductor component according to Claim 1, characterized in that
(a) the emitter layer (9) is divided into individual second emitter regions (25) which are located opposite a cathode short-circuit region (18) in each case;
(b) between the second emitter regions (25) and opposite a first emitter region (20) in each case, a second channel region (21) of the second conductivity type projects from the second principal face (H2) into the first base layer (8);
(c) anode short-circuit regions (24) of the first conductivity type are let into the second channel regions (21) from the second principal face (H2) in each case and are contacted by the anode contact (23), the second channel regions (21) being led up outside the anode short-circuit regions (24) to the second principal face (H2); and
(d) second gate electrodes (22) are provided which are arranged above the second principal face (H2) over the led-up second channel regions (21) and insulated from the semiconductor substrate (14).

7. Power semiconductor component according to Claim 1, characterized in that
(a) a continuous interlayer (28) of the first conductivity type is arranged between the first base layer (8) and the emitter layer (9);
(b) the second base layer (7) is interrupted in predetermined regions, and the first base layer (8) is led up there to the first principal face (H1);
(c) in these predetermined regions the emitter layer (9) is interrupted and the interlayer (28) is led up to the second principal face (H2); and
(d) in these predetermined regions, an extraction region (27) of the second conductivity type projects in each case from the first principal face (H1) into the first base layer (8), and is contacted by the cathode contact (1).

8. Power semiconductor component according to one of Claims 1 to 7, characterized in that the first conductivity type is the n-type and the second conductivity type is the p-type.

9. Power semiconductor component according to Claim 8, characterized in that the first base layer (8) is n⁻-doped, the second base layer (7) is p-doped, the emitter layer (9) and the cathode short-circuit regions (18) are p⁺-doped, the first channel regions (19) are n-doped and the first emitter regions (20) are n⁺-doped.

## Revendications

1. Dispositif semi-conducteur de puissance, ouvrable, à commande de type MOS, comprenant
(a) un substrat semi-conducteur (14) d'un premier type de conductibilité, lequel substrat semi-conducteur (14) est limité d'un côté par une première surface principale (H1) et de l'autre côté par une deuxième surface principale (H2) et dont la partie interne forme une première couche de base (8) ;
(b) une couche d'émetteur (9) d'un deuxième type de conductibilité opposé au premier, laquelle couche d'émetteur (9) pénètre dans la première couche de base (8) à partir de la deuxième surface principale (H2) ;
(c) une deuxième couche de base (7) du deuxième type de conductibilité, laquelle deuxième couche de base (7) pénètre dans la première couche de base (8) à partir de la première surface principale (H1) ;
(d) une pluralité de premières zones d'émetteur (20) du premier type de conductibilité, lesquelles pénètrent dans la deuxième couche de base (7) à partir de la première surface principale (H1) ;
(e) une pluralité de premières zones de canal (19) du premier type de conductibilité, lesquelles pénètrent dans la deuxième couche de base (7) à partir de la première surface principale (H1) ;
(f) une pluralité de zones de court-circuit de la cathode (18) du deuxième type de conductibilité, lesquelles sont introduites à chaque fois dans les premières zones de canal (19) à partir de la première surface principale (H1), les premières zones de canal (19) étant remontées à l'extérieur des zones de court-circuit de la cathode (18) jusqu'à la première surface principale (H1) ;
(g) des premières électrodes de gâchette (3), lesquelles sont disposées au-dessus de la première surface principale (H1) à chaque fois sur les premières zones de canal (19) remontées et sont isolées du substrat semi-conducteur (14) ;
(h) un contact de cathode (1), lequel est monté sur la première surface principale (H1) et établit le contact entre les premières zones d'émetteur (20) et les zones de court-circuit de la cathode (18) ; et
(i) un contact d'anode (10), lequel est monté sur la deuxième surface principale (H2) et établit le contact avec la couche d'émetteur (9) ;
caractérisé par le fait que
(k) les premières zones d'émetteur (20) et les premières zones de canal (19) sont séparées les unes des autres par la deuxième couche de base (7) et disposées latéralement les unes à côté des autres et pénètrent dans la deuxième couche de base (7), chaque première zone d'émetteur (20) et chaque première zone de canal (19) formant ainsi une cellule d'émetteur (E) ou une cellule DMOS (D) avec la zone de court-circuit de cathode (18) y étant introduite et avec les couches situées en dessous (7, 8, 9), lesquelles cellules sont disposées les unes à côté des autres et sont raccordées électriquement en parallèle.

2. Dispositif semi-conducteur de puissance conforme à la revendication 1, caractérisé par le fait
(a) qu'en plus des cellules d'émetteur (E) et des cellules DMOS (D) sont prévues des cellules de fermeture (S), lesquelles sont disposées entre les cellules d'émetteur (E) et les cellules DMOS (D) et branchées en parallèle avec elles, chaque cellule de fermeture (S) étant adjacente à au moins une cellule d'émetteur (E) voisine ;
(b) qu'à l'intérieur de chaque cellule de fermeture (S), la deuxième couche de base (7) et, dans une interruption de la deuxième couche de base (7), la première couche de base (8) sont remontées l'une après l'autre vers la première surface principale (H1), la première couche de base (8) formant une zone de fermeture (26) entourée par la deuxième couche de base (7) ; et
(c) qu'à l'intérieur de chaque cellule de fermeture (S), la première électrode de gâchette (3) couvre également la deuxième couche de base (7) remontée entre la zone de fermeture (26) et la première zone d'émetteur (20) de la cellule d'émetteur (E) voisine.

3. Dispositif semi-conducteur de puissance conforme à la revendication 2, caractérisé par le fait qu'au moins une partie des cellules d'émetteur (E), des cellules DMOS (D) et des cellules de fermeture (S) sont réalisées sous la forme de bandes.

4. Dispositif semi-conducteur de puissance conforme à la revendication 3, caractérisé par le fait que les cellules de fermeture (S) sont spécialement réalisées sous la forme de bandes de fermeture (29).

5. Dispositif semi-conducteur de puissance conforme à la revendication 1, caractérisé par le fait que le nombre de cellules DMOS (D) est supérieur ou égal au nombre de cellules d'émetteur (E).

6. Dispositif semi-conducteur de puissance conforme à la revendication 1, caractérisé par le fait que
(a) la couche d'émetteur (9) est partagée en deuxièmes zones d'émetteur (25) individuelles qui sont à chaque fois disposées en opposition d'une zone de court-circuit de cathode (18) ;
(b) une deuxième zone de canal (21) du deuxième type de conductibilité pénètre, entre les deuxièmes zones d'émetteur (25) et à chaque fois en opposition avec une première zone d'émetteur (20) dans la première couche de base (8) à partir de la deuxième surface principale (H2) ;
(c) des zones de court-circuit d'anode (24) du premier type de conductibilité sont introduites à chaque fois dans les deuxièmes zones de canal (21) à partir de la deuxième surface principale (H2) et sont mises en contact par le contact d'anode (23), les deuxièmes zones de canal (21) étant remontées à l'extérieur des zones de court-circuit d'anode (24) jusqu'à la deuxième surface principale (H2) ; et
(d) il est prévu des deuxièmes électrodes de gâchette (22), lesquelles sont disposées au-dessus de la deuxième surface principale (H2) sur les deuxièmes zones de canal (21) remontées et sont isolées du substrat semi-conducteur (14).

7. Dispositif semi-conducteur de puissance conforme à la revendication 1, caractérisé par le fait que
(a) une couche intermédiaire (28) continue du premier type de conductibilité est disposée entre la première couche de base (8) et la couche d'émetteur (9) ;
(b) la deuxième couche de base (7) est interrompue dans des zones prédéfinies et la première couche de base (8) y est remontée jusqu'à la première surface principale (H1) ;
(c) la couche d'émetteur (9) est interrompue dans ces zones prédéfinies et la couche intermédiaire (28) y est remontée vers la deuxième surface principale (H2) ; et
(d) dans ces zones prédéfinies, une zone d'extraction (27) du deuxième type de conductibilité pénètre à chaque fois dans la première couche de base (8) à partir de la première surface principale (H1) et son contact est établi par le contact de cathode (1).

8. Dispositif semi-conducteur de puissance conforme à l'une des revendications 1 à 7, caractérisé par le fait que le premier type de conductibilité est du type n et le deuxième type de conductibilité est du type p.

9. Dispositif semi-conducteur de puissance conforme à la revendication 8, caractérisé par le fait que la première couche de base (8) est dopée n⁻, que la deuxième couche de base (7) est dopée p et que la couche d'émetteur (9) et les zones de court-circuit de la cathode (18) sont dopées p⁺, que les premières zones de canal (19) sont dopées n et que les premières zones d'émetteur (20) sont dopées n⁺.
